# EUROPEAN PATENT SPECIFICATION

(11) **EP 0 433 120 B1**
(45) Date of publication and mention of the grant of the patent: **15.02.1995**
(21) Application number: 90403253.9
(22) Date of filing: 16.11.1990
(51) Int. Cl.: H03L 7/095, H03L 7/183

(54) **PLL synthesizer circuit**
PLL-Synthesiererschaltung
circuit synthétiseur PLL

(30) Priority: 16.11.1989 JP 300283/89
(43) Date of publication of application: 19.06.1991
(73) Proprietor: FUJITSU LIMITED, Kawasaki-shi, Kanagawa 211 (JP); FUJITSU VLSI LIMITED, Kasugai-shi Aichi 487 (JP)
(72) Inventor: Saito, Shinji, Tajimi-shi, Gifu 507 (JP); Kobayashi,Akira, Kasugai-shi, Aichi 487 (JP)
(74) Representative: Joly, Jean-Jacques

(56) References cited:
- EP-A- 0 024 878
- EP-A- 0 332 467
- GB-A- 2 180 708
- US-A- 4 408 333

## Description

### BACKGROUND OF THE INVENTION

The present invention generally relates to a phase-locked loop (PLL), and more particularly to a circuit for detecting a phase-locked state of a PLL synthesizer circuit.

Recently, a PLL synthesizer circuit is widely used in various communication systems. In the field of communication systems, there is a need to provide a digitized phase lock detecting circuit in order to make the PLL synthesizer circuit compact and avoid an adjustment operation thereon.

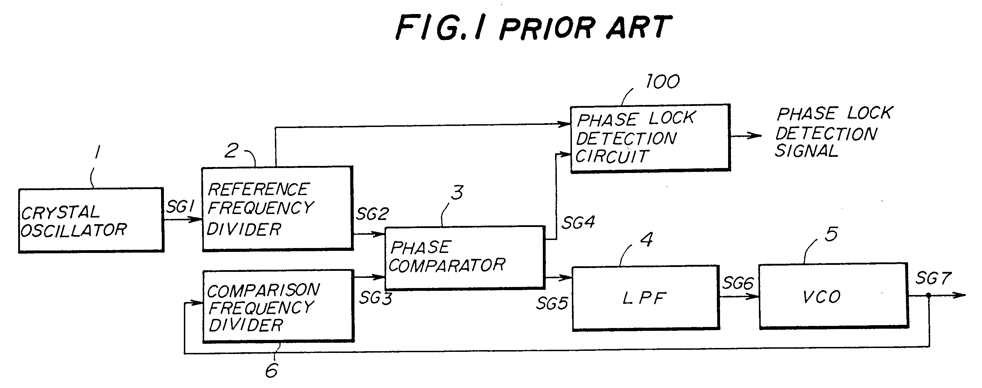

Referring to FIG.1, there is illustrated a basic configuration of a PLL synthesizer circuit. A crystal oscillator 1 generates a signal SG1 having an inherent frequency based on a vibration of a built-in crystal vibration element. A reference frequency divider 2 receives the signal SG1 and divides the frequency thereof to thereby generate a reference signal SG2 having an appropriate frequency lower than the frequency of the signal SG1. The reference signal SG2 generated. and output by the reference frequency divider 2 is input to a phase comparator 3.

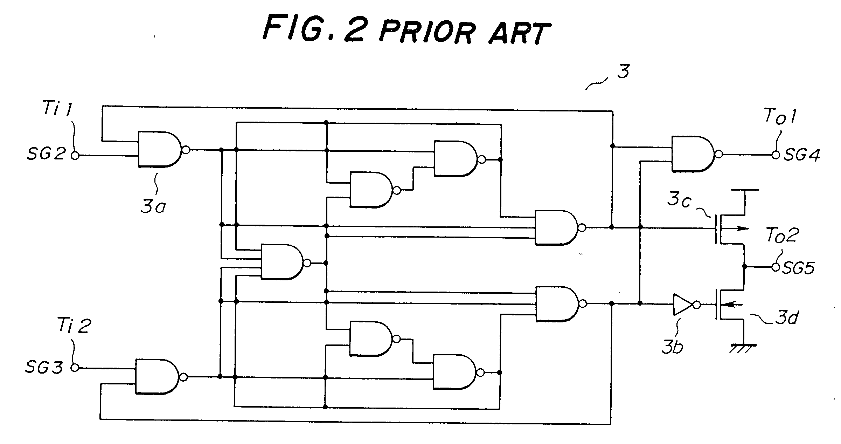

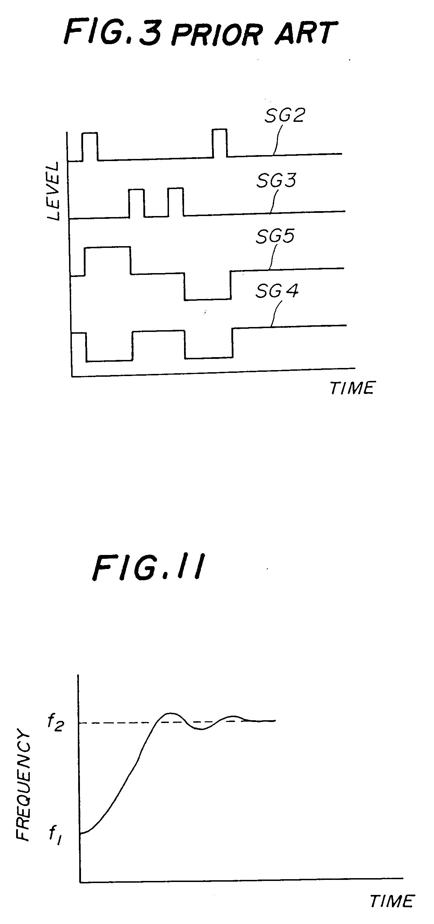

FIG.2 is a circuit diagram of the phase comparator 3. As shown, the phase comparator 3 is composed of NAND circuits 3a, an inverter 3b, a P-channel MOS transistor 3c and an N-channel MOS transistor 3d. The phase comparator 3 has two input terminals Ti1 and Ti2, and two output terminals To1 and To2. The reference signal SG2 is applied to the input terminal Ti1, and a signal SG3 generated by a comparison frequency divider 6 is applied to the input terminal Ti2. The reference signal SG2 and the signal SG3 respectively have waveforms as shown in FIG.3. In response to the reference signal SG2 and the signal SG3, the phase comparator 3 outputs signals SG4 and SG5 to the output terminals To1 and To2, respectively. The signals SG4 and SG5 are based on the phase difference between the reference signal SG2 and the signal SG3. The signal SG4 is input to a phase lock detecting circuit 100, and the signal SG5 is input to a lowpass filter (LPF) 4.

The lowpass filter 4 smooths the signal SG5 of the phase comparator 3 and outputs a direct-current voltage signal SG6, which is then input to a voltage-controlled oscillator (VCO) 5. The voltage-controlled oscillator 5 varies the oscillation frequency of a signal SG7 on the basis of the direct-current voltage of the signal SG6. The signal SG7 is input to the comparison frequency divider 6, which divides the frequency of the signal SG7 and thereby generates the aforementioned signal SG3.

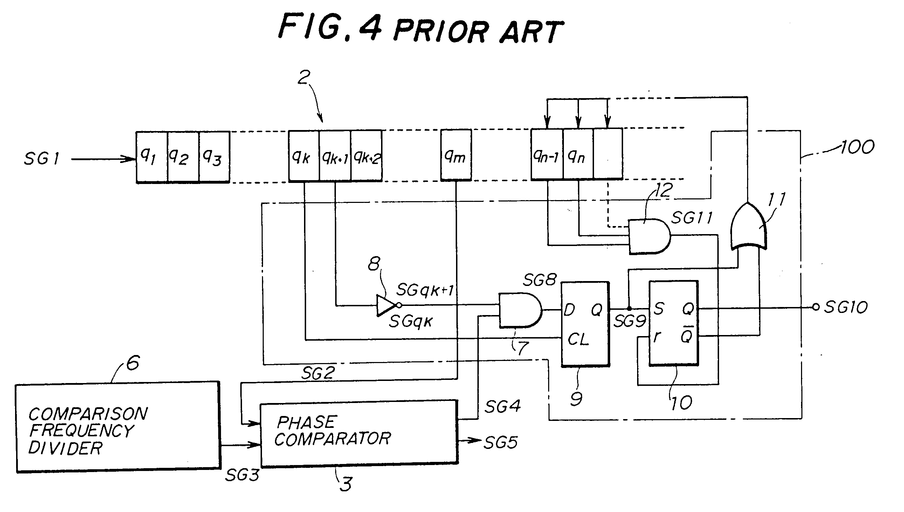

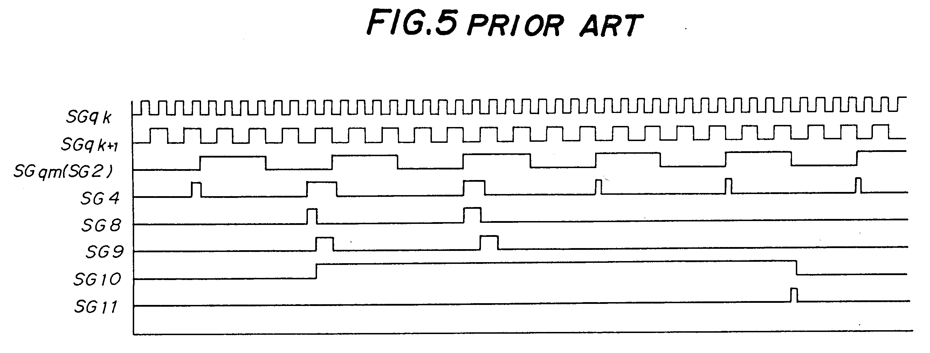

A digitized structure of the phase lock detecting circuit 100 is illustrated in FIG.4. The reference frequency divider 2 is composed of a plurality of frequency dividers q1 - qn connected in series. The signal SG1 generated and output by the crystal oscillator 1 is input to the frequency divider q1 of the first stage. The frequency dividers q1 - qn divide the frequencies of the respective input signals, and generate respective output signals having frequencies equal to 1/2 of the respective input signals. When the frequency divider qk generates an output signal SGqk, as shown in FIG.5, the frequency divider qk+1 generates an output signal SGqk+1 having a frequency equal to half the frequency of the output signal SGqk. In this way, the frequency divider qm generates an output signal SGqm.

The input terminal Ti1 of the phase comparator 3 is supplied with, as the reference signal SG2, the output signal SGqm of the frequency divider qm. The phase comparator 3 outputs the signal SG4 based on the phase difference between the reference signal SG2 and the signal SG3 generated and output by the comparison frequency divider 6.

The phase lock detecting circuit 100 is composed of a two-input AND circuit 7, an inverter 8, a D-type flip-flop 9, an RS-type flip-flop 10, a two-input OR circuit 11 and a two-input AND circuit 12. The signal SG4 generated and output by the phase comparator 3 is applied to one of the two input terminals of the AND circuit 7, and the output signal SGqk+1 of the frequency divider qk+1 is applied to the other input terminal of the AND circuit 7. Thus, as shown in FIG.5, when the signal SG4 from the phase comparator 3 has a pulse width greater than that of the output signal SGqk+1 of the frequency divider qk+1, the AND circuit 7 outputs a signal SG8 having a high level. The signal SG8 thus generated is input to a terminal D of the D-type flip-flop 9.

The D-type flip-flop 9 is supplied with, as a clock signal, the output signal SGqk of the frequency divider qk. The D-type flip-flop 9 generates a signal SG9 from the clock signal as well as the signal SG8 from the AND circuit 7, as shown in FIG.5. That is, the output signal SG9 rises when the signal SGqk output from the frequency divider qk falls in a state where the signal SG8 from the AND circuit 7 is at the high level, and falls in response to the next fall of the signal SGqk. The signal SG9 thus generated is drawn from a terminal Q of the D-type flip-flop 9 and then input to a terminal S of the RS-type flip-flop 10.

The RS-type flip-flop 10 outputs, as a phase unlock detection signal, a signal SG10 at the high level in accordance with the high-level output signal SG9. When the high-level signal SG10 is generated, the oscillation frequency of the voltage-controlled oscillator 5 is out of the phase-locked state ( in the phase-unlocked state). As the phase and frequency of the signal SG3 output by the comparison frequency divider 6 become close to those of the signal SG2 output by the reference frequency divider 2 due to the function of the PLL synthesizer circuit, the pulse width of the signal SG4 output by the phase comparator 3 decreases. Then, the output signal SG10 of the RS-type flip-flop 10 is switched to the low level and the PLL synthesizer circuit is restored to the phase locked state. A signal SG11 for resetting the RS-type flip-flop 10 is generated by the AND circuit 12, which receives the output signals of the frequency dividers qn-1 and qn. The OR circuit 11 receives the signal SG9 and an inverted version of the signal SG10, and outputs an OR operation result thereon to the frequency dividers qn-1 and qn. The pulse width of the signal SG10 is defined by the signal SG11. It is possible to adjust the pulse width of the signal SG10 by supplying the AND circuit 12 with the signals of different frequency dividers.

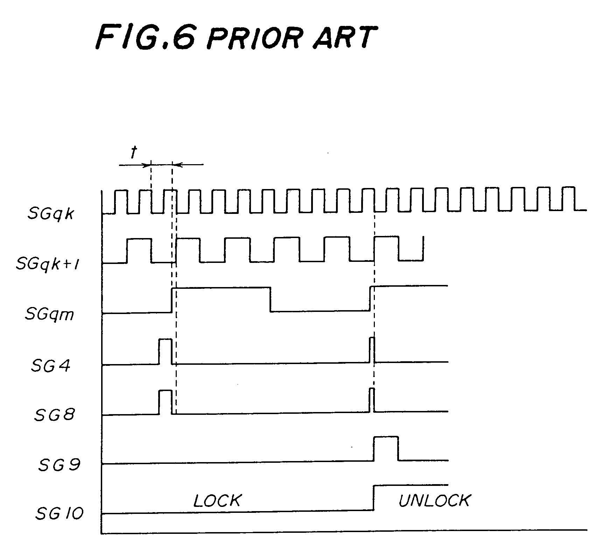

It should be noted that the waveform diagram of FIG.5 is illustrated without taking into account an operational delay time caused by the frequency dividers q1 - qn connected in series. A slight delay time takes place until each of the frequency dividers starts to operate in response to the output signal of the immediately previous frequency divider. Such a slight delay time is accumulated. An accumulated delay time causes the following problems. As shown in FIG.6, if there is a slight delay time t between the signal SGqk of the frequency divider qk and the signal SGgm of the frequency divider qm, the phase comparator 3 outputs the signal SG4 having a small pulse width. In the case where the signal SG10 maintained at the low level is output, as the phase lock detection signal, from the RS-type flip-flop 10, there is a possibility that the signal SG4 having a small pulse width passes through the AND circuit 7, and is output as it is, as the signal SG8. Then, the signal SG8 having the small pulse width causes the D-type flip-flop 9 to output the high-level signal SG9. Thus, the RS-type flip-flop 10 outputs the high-level signal SG10, as the phase unlock detection signal irrespective of the PLL synthesizer circuit is in the phase-locked state. The signal SG10 is used for, for example, a communication device capable of communicating with another party at an arbitrary frequency. When the phase unlock detection signal is generated irrespective of the PLL synthesizer circuit is correctly in the phase-locked state, the established communication channel will be destroyed.

A circuit corresponding to the preamble of claim 1 is known from patent document GB-A-2 180 708.

### SUMMARY OF THE PRESENT INVENTION

It is a general object of the present invention to provide an improved PLL synthesizer circuit having an improved circuit capable of correctly detecting the state of the PLL synthesizer circuit by detecting the pulse width of a signal indicative of the phase difference between the reference frequency and the oscillation frequency of the PLL synthesizer circuit.

The above-mentioned object of the present invention is achieved by a PLL synthesizer circuit as defined in claim 1.

### BRIEF DESCRIPTION OF THE DRAWINGS

Other objects, features and advantages of the present invention will become more apparent from the following detailed description when read in conjunction with the accompanying drawings, in which:
FIG.1 is a block diagram of a PLL synthesizer circuit;
FIG.2 is a circuit diagram of a phase comparator shown in FIG.1;
FIG.3 is a waveform diagram illustrating the operation of the phase comparator shown in FIG.2;
FIG.4 is a block diagram illustrating a conventional phase lock detecting circuit shown in FIG.1;
FIG.5 is a waveform diagram illustrating the operation of the configuration shown in FIG.4 in which an operational delay time caused by a reference frequency divider shown in FIG.4 is neglected;
FIG.6 is a waveform diagram illustrating the operation of the configuration shown in FIG.4 in which the operational delay time caused by the reference frequency divider shown in FIG.4 is taken into account;
FIG.7 is a block diagram of a PLL synthesizer circuit having a pulse width detecting circuit in which the pulse width detecting circuit is applied for a PLL synthesizer circuit and serves as a phase lock detecting circuit;
FIG.8 is a waveform diagram illustrating the operation of the phase lock detecting circuit shown in FIG.7;
FIG.9 is a block diagram illustrating a PLL synthesizer circuit having a phase lock detecting circuit according to a second preferred embodiment of the present invention;
FIG.10 is a waveform diagram illustrating the operation of the phase lock detecting circuit shown in FIG.9;
FIG.11 is a graph illustrating a change of the oscillation frequency of the PLL synthesizer as a function of time; and
FIG.12 is a block diagram illustrating a PLL synthesizer circuit having a phase lock detecting circuit according to a third preferred embodiment of the present invention.

### DESCRIPTION OF THE PREFERRED EMBODIMENTS

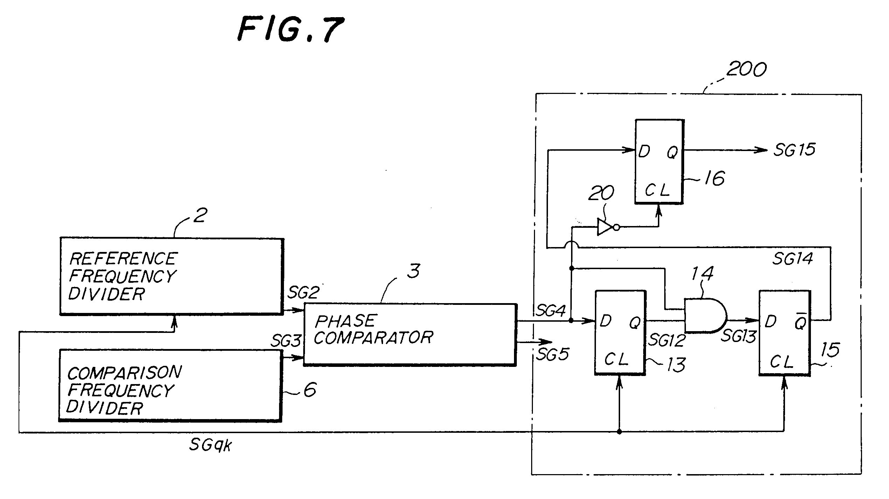

Referring to FIG.7, there is illustrated a pulse width detecting circuit according to a first preferred embodiment of the present invention. The pulse width detecting circuit shown in FIG.7 serves as a phase lock detecting circuit. In FIG.7, those parts which are the same as those shown in the previous figures are given the same reference numerals. A phase lock detecting circuit 200 is composed of a D-type flip-flop 13, a two input AND circuit 14, a D-type flip-flop 15, a D-type flip-flop 16, and an inverter 20.

The phase comparator 3 outputs the signals SG4 and SG5 having the pulse widths which vary in accordance with the phase difference between the signals SG2 and SG3. The signal SG4 is input to a terminal D of the D-type flip-flop 13, one of the two input terminals of the AND circuit 14, and the inverter 20. An output signal SG12 obtained at a terminal Q of the D-type flip-flop 13 is input to the other input terminal of the AND circuit 14, which generates a signal SG13. An output terminal of the AND circuit 14 is connected to a terminal D of the flip-flop 15. An output terminal Q̅ of the D-type flip-flop 15 is connected to a terminal D of the D-type flip-flop 16, which outputs a signal SG14. A reference clock signal SGqk generated by the reference frequency divider 2 is applied to clock terminals CL of the D-type flip-flops 13 and 15. A clock terminal CL of the D-type flip-flop 16 is supplied with an inverted version of the signal SG4 generated by the inverter 20. The D-type flip-flop 16 outputs a phase lock detection signal SG15 (which also functions as a phase unlock detection signal) via a terminal Q thereof.

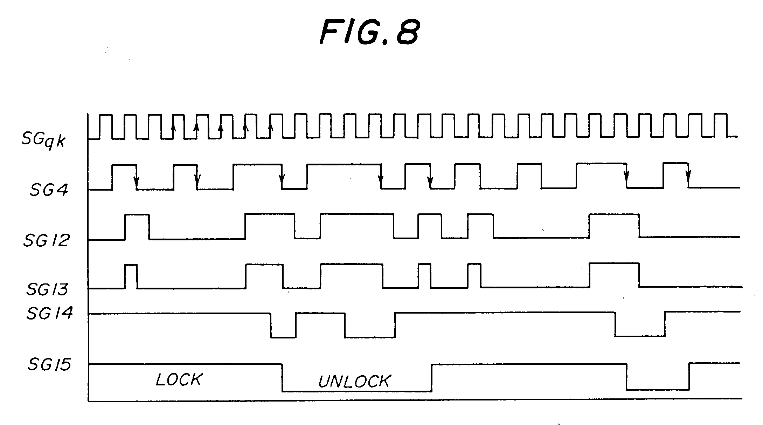

FIG.8 is a waveform diagram illustrating the operation of the phase lock detecting circuit shown in FIG.7. The D-type flip-flops 13 and 15 respectively latch the corresponding input signals in synchronism with the rise of the reference clock signal SGqk generated by the reference frequency divider 2. A signal SG13 output by the AND. circuit 14 has a pulse width in which the pulse width of the signal SG4 and the pulse width of a signal SG12 output by the D-type flip-flop 13 overlap with each other. The D-type flip-flop 15 changes an output signal SG14 obtained at an output terminal Q̅ thereof from a high level to a low level when the reference clock signal SGqk rises in a state where the signal SG13 output by the AND circuit 14 is maintained at the high level. In other words, the signal SG14 falls when the signal SG13 is continuously maintained at the high level during a time when the reference clock signal SGqk rises twice. The D-type flip-flop 16 latches the signal SG14 when the signal SG4 falls. In the above-mentioned way, when the signal SG4 has a pulse width in which the reference clock signal SGqk rises twice, the phase lock detecting circuit 200 outputs the low-level signal SG15 which indicates that the PLL synthesizer is in the phase-unlocked state.

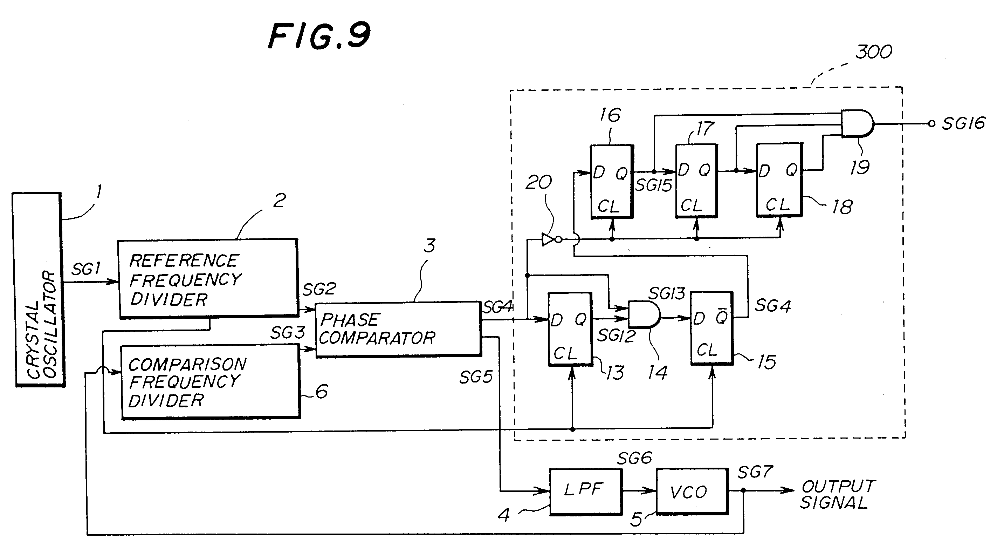

FIG.9 illustrates a PLL synthesizer circuit having a phase lock detecting circuit 300 according to a second preferred embodiment of the present invention. In FIG.9, those parts which are the same as those shown in FIG.7 are given the same reference numerals. The phase lock detecting circuit 300 includes two D-type flip-flops 17 and 18, and a three-input AND circuit 19 in addition to the phase lock detecting circuit 200 shown in FIG.7. The terminal Q of the D-type flip-flop 16 is connected to a terminal D of the D-type flip-flop 17 and one of the three input terminals of the AND circuit 19. A terminal Q of the D-type flip-flop 17 is connected to a terminal D of the D-type flip-flop 18 and one of the three input terminals of the AND circuit 19. A terminal Q of the D-type flip-flop 18 is connected to one of the three input terminals of the AND circuit 19. The inverted version of the signal SG4 output by the phase comparator 3 is applied to clock terminals CL of the D-type flip-flops 16 - 19.

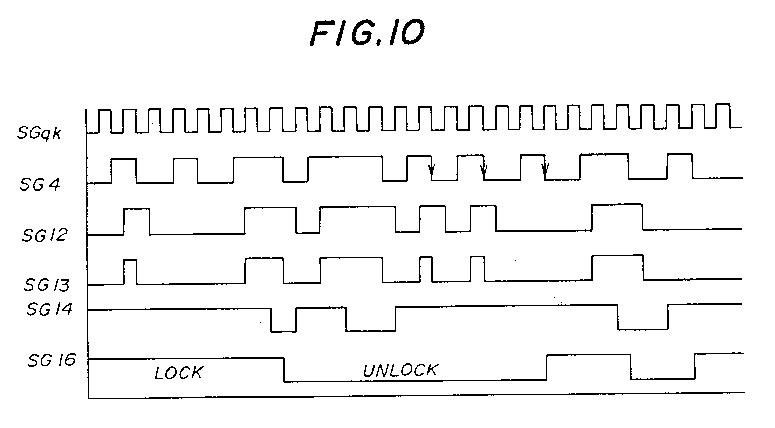

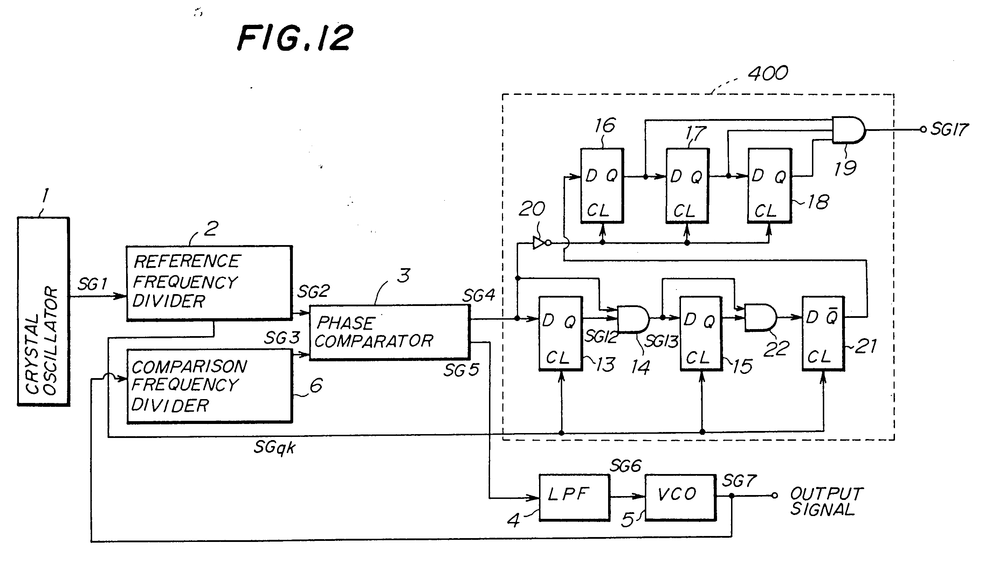

During operation, when the signal SG4 shown in FIG.10 is input to the phase lock detecting circuit 300, the D-type flip-flop 13 outputs the signal SG12 generated from the signal SG4 and the reference clock signal SGqk to the AND circuit 14. Then, the AND circuit 14 outputs the signal SG13 to the D-type flip-flop 15. The D-type flip-flop 15 outputs the signal SG14 from the signal SG13 and the reference clock signal SGqk to the D-type flip-flop 16. The D-type flip-flops 16, 17 and 18, and the AND circuit 19 functions to change a lock detection signal SG16 from a low level to a high level when the signal SG14 output by the D-type flip-flop 15 is continuously at the high level during a time when the signal SG4 output by the phase comparator 3 successively falls three times. In other words, when the phase lock detection signal is successively output three times in synchronism with the inverted version of the signal SG4, it is concluded that the PLL synthesizer is definitely in the phase locked state. This arrangement is taken into account a case as shown in FIG.11. When the PLL synthesizer circuit changes its oscillation frequency from f1 to f2, a ringing of the oscillation frequency may initially occur. The combination of the D-type flip-flops 16 - 19 and the AND circuit 19 makes it possible to generate the lock detection signal when the initial ringing decreases sufficiently.

As described above, by adding two D-type flip-flops 17 and 19, and the AND circuit 19, the phase lock detecting circuit 300 determines whether or not the phase lock detection signal is successively output three times. It is also possible to provide m flip-flops (m is arbitrary equal to or greater than 2) and a single AND circuit for the above-mentioned purpose.

Referring to FIG.12, there is illustrated a PLL synthesizer circuit having a phase lock detecting circuit 400 according to a third preferred embodiment of the present invention. In FIG.12, those parts which are the same as those shown in FIG.9 are given the same reference numerals. The phase lock detecting circuit 400 is configured by adding an AND circuit 22 and a D-type flip-flop 21 to the phase lock detection circuit 300 shown in FIG.9. The terminal Q of the D-type flip-flop 15 is connected to one of the two input terminals of the AND circuit 22. The other input terminal of the AND circuit 22 is supplied with the signal SG13. An output terminal of the AND circuit 22 is connected to a terminal D of the D-type flip-flop 21. A terminal Q̅ of the D-type flip-flop 21 is connected to the terminal D of the D-type flip-flop 16. The reference clock signal SGqk generated by the reference frequency divider 2 is applied to a clock terminal CL of the D-type flip-flop 21. The AND circuit 19 outputs a phase lock detection signal SG17.

The combination of the D-type flip-flops 13, 15 and 21, and the AND circuits 14 and 20 function to detect a pulse width of the signal SG4 in which the reference clock signal SGqk successively rises three times. Thus, the phase lock detecting circuit 400 detects a wider frequency locking range than that detected by the phase lock detecting circuit 200 shown in FIG. 7.

The above-mentioned embodiments of the present invention checks the pulse width of the phase difference signal SG4 two or three times in synchoronism with the reference clock signal SGqk. It is also possible to check the pulse width of the phase difference signal SG4 four or more times. As the frequency of the reference clock signal SGqk increases, it is sufficient to detect the same pulse width by checking the pulse width of the phase difference signal a smaller number of times.

## Claims

1. A PLL synthesizer circuit comprising:
reference frequency generating means (1, 2) for generating a reference frequency signal (SG2) and a reference clock signal (SGqk);
phase comparing means (3) for comparing a phase of said reference frequency signal with an output signal (SG3) and for outputting a phase difference signal (SG4) having a pulse form; and
voltage-controlled oscillation means (4, 5, 6), coupled to said phase comparing means, for generating said output signal having a frequency dependent on said phase difference signal,
phase lock detecting means (200, 300, 400), coupled to said phase comparing means,
characterized in that said phase lock detecting means comprises means for determining whether or not said phase difference signal has a pulse width in which said reference clock signal successively changes n times (n is a numeral equal to or greater than 2) and for outputting a phase lock detection signal (SG15, SG16, SG17) signalling that said PLL synthesizer circuit is in a phase-locked state when said reference clock signal does not successively change n times in said pulse width of said phase difference signal.

2. A PLL synthesizer circuit as claimed in claim 1, characterized in that said phase lock detecting means (200) comprises:
first, second and third flip-flops (13, 15, 16), each having an input terminal, an output terminal and a clock terminal;
an AND circuit (14) having a first input terminal, a second input terminal and an output terminal; and
an inverter (20), and in that:
the input terminal of said first flip-flop receives said phase difference signal;
the output terminal of said first flip-flop is connected to the first input terminal of said AND circuit;
the second input terminal of said AND circuit receives said phase difference signal;
the output terminal of said AND circuit is connected to the input terminal of said second flip-flop;
said reference clock signal is supplied to said clock terminal of each of said first and second flip-flops;
the output terminal of said second flip-flop is connected to the input terminal of said third flip-flop;
the clock terminal of said third flip-flop receives an inverted version of said phase difference signal generated by said inverter; and
said phase lock detection signal is output via the output terminal of said third flip-flop.

3. A PLL synthesizer circuit as claimed in claim 2, characterized in that:
said first, second and third flip-flops (13, 15, 16) are respectively formed of D-type flip-flops;
each of said first and third D-type flip-flops has an output terminal Q serving as the output terminal of each of said first and third flip-flops; and
said second D-type flip-flop has an inverted terminal Q̅ serving as the output terminal of said second flip-flop.

4. A PLL synthesizer circuit as claimed in claim 1, characterized in that said phase lock detecting means (300, 400) comprises decision means (17, 18, 19) for determining whether or not said phase lock detection signal (SG15) is successively generated a predetermined number of times in synchronism with a change of said phase difference signal and for outputting a phase lock detection signal (SG16, SG17) indicating that said PLL synthesizer circuit is definitely in the phase-locked state when it is determined said phase lock detection signal is successively generated said predetermined number of times.

5. A PLL synthesizer circuit as claimed in claim 4, characterized in that said decision means comprises m (m is an integer equal to or greater than 2) flip-flops (17, 18) connected in series, and an AND circuit (19), in that:
each of said m flip-flops has an input terminal, an output terminal and a clock terminal;
the input terminal of one of said m flip-flops at a first stage is connected to the output terminal of said third flip-flop;
the output terminal of each of said m flip-flops is connected to said AND circuit;
said inverted version of said reference clock signal is applied to the clock terminal of each of said m flip-flops; and
said phase lock detection signal indicating that said PLL synthesizer circuit is definitely in the phase-locked state is output via the AND circuit.

6. A PLL synthesizer circuit as claimed in claim 5, characterized in that said m flip-flops are respectively formed of D-type flip-flops.

7. A PLL synthesizer circuit as claimed in claim 1, characterized in that said phase lock detecting means (400) comprises:
first, second, third and fourth flip-flops (13, 15, 21, 16), each having an input terminal, an output terminal and a clock terminal;
first and second AND circuits (14, 22), each having a first input terminal, a second input terminal and an output terminal; and
an inverter (20), and in that:
the input terminal of said first flip-flop receives said phase difference signal;
the output terminal of said first flip-flop is connected to the first input terminal of said first AND circuit;
the second input terminal of said first AND circuit receives said phase difference signal;
the output terminal of said first AND circuit is connected to the input terminal of said second flip-flop;
the first and second input terminals of said second AND circuit are connected to the output terminal of said first AND circuit and the output terminal of said second flip-flop, respectively;
said reference clock signal is supplied to said clock terminal of each of said first, second and third flip-flops;
the output terminal of said third flip-flop is connected to the input terminal of said fourth flip-flop;
the clock terminal of said fourth flip-flop receives an inverted version of said phase difference signal generated by said inverter; and
said phase lock detection signal is output via the output terminal of said fourth flip-flop.

8. A PLL synthesizer circuit as claimed in claim 7, characterized in that said phase lock detecting means (400) comprises decision means (17, 18, 19) for determining whether or not said phase lock detection signal is successively generated a predetermined number of times in synchronism with a change of said phase difference signal and for outputting a phase lock detection signal indicating that said PLL synthesizer circuit is definitely in the phase-locked state when it is determined said phase lock detection signal is successively generated said predetermined number of times.

9. A PLL synthesizer circuit as claimed in claim 7, characterized in that said first, second, third and fourth flip-flops are respectively formed of D-type flip-flops.

10. A PLL synthesizer circuit as claimed in claim 1, characterized in that:
said phase lock detection signal has a first level obtained when it is determined that said reference clock signal does not successively change n times in said pulse width of said phase difference signal, and a second level obtained when it is determined that said reference clock signal successively changes n times in said pulse width; and
said first level indicating that said PLL synthesizer circuit is in the phase-locked state, and said second level indicating that said PLL synthesizer circuit is in a phase-unlocked state.

## Patentansprüche

1. Eine PLL-Synthetisiererschaltung mit:
Bezugsfrequenzerzeugungsmitteln (1, 2) zum Erzeugen eines Bezugsfrequenzsignals (SG2) und eines Bezugstaktsignals (SGqk);
einem Phasenvergleichsmittel (3) zum Vergleichen einer Phase des genannten Bezugsfrequenzsignals mit einem Ausgangssignal (SG3) und zum Ausgeben eines Phasendifferenzsignals (SG4), das eine Impulsform hat;
spannungsgesteuerten Oszillationsmitteln (4, 5, 6), die mit dem genannten Phasenvergleichsmittel gekoppelt sind, zum Erzeugen des genannten Ausgangssignals, das eine Frequenz hat, die von dem genannten Phasendifferenzsignal abhängt; und
einem Phasenverriegelungsdetektionsmittel (200, 300, 400), das mit dem genannten Phasenvergleichsmittel gekoppelt ist,
dadurch gekennzeichnet, daß das genannte Phasenverriegelungsdetektionsmittel ein Mittel umfaßt, zum Bestimmen, ob das genannte Phasendifferenzsignal eine Impulsbreite hat, in der sich das genannte Bezugstaktsignal n-mal (n ist eine Zahl gleich oder größer als 2) sukzessive ändert oder nicht, und zum Ausgeben eines Phasenverriegelungsdetektionssignals (SG15, SG16, SG17), das signalisiert, daß die genannte PLL-Synthetisiererschaltung in einem phasenverriegelten Zustand ist, wenn sich das genannte Bezugstaktsignal in der genannten Impulsbreite des genannten Phasendifferenzsignals nicht n-mal sukzessive ändert.

2. Eine PLL-Synthetisiererschaltung nach Anspruch 1, dadurch gekennzeichnet, daß das genannte Phasenverriegelungsdetektionsmittel (200) umfaßt:
erste, zweite und dritte Flipflops (13, 15, 16), von denen jedes einen Eingangsanschluß, einen Ausgangsanschluß und einen Taktanschluß hat;
eine UND-Schaltung (14) mit einem ersten Eingangsanschluß, einem zweiten Eingangsanschluß und einem Ausgangsanschluß; und
einen Inverter (20), und daß:
der Eingangsanschluß des genannten ersten Flipflops das genannte Phasendifferenzsignal empfängt;
der Ausgangsanschluß des genannten ersten Flipflops mit dem ersten Eingangsanschluß der genannten UND-Schaltung verbunden ist;
der zweite Eingangsanschluß der genannten UND-Schaltung das genannte Phasendifferenzsignal empfängt;
der Ausgangsanschluß der genannten UND-Schaltung mit dem Eingangsanschluß des genannten zweiten Flipflops verbunden ist;
das genannte Bezugstaktsignal dem genannten Taktanschluß von jedem der genannten ersten und zweiten Flipflops zugeführt wird;
der Ausgangsanschluß des genannten zweiten Flipflops mit dem Eingangsanschluß des genannten dritten Flipflops verbunden ist;
der Taktanschluß des genannten dritten Flipflops eine invertierte Version des genannten Phasendifferenzsignals empfängt, das durch den genannten Inverter erzeugt wurde; und
das genannte Phasenverriegelungsdetektionssignal über den Ausgangsanschluß des genannten dritten Flipflops ausgegeben wird.

3. Eine PLL-Synthetisiererschaltung nach Anspruch 2, dadurch gekennzeichnet, daß:
die genannten ersten, zweiten und dritten Flipflops (13, 15, 16) jeweils aus D-Typ-Flipflops gebildet sind;
jedes der genannten ersten und dritten D-Typ-Flipflops einen Ausgangsanschluß Q hat, der als Ausgangs-anschluß von jedem der genannten ersten und dritten Flipflops dient; und
das genannte zweite D-Typ-Flipflop einen invertierten Anschluß Q̅ hat, der als Ausgangsanschluß des genannten zweiten Flipflops dient.

4. Eine PLL-Synthetisiererschaltung nach Anspruch 1, dadurch gekennzeichnet, daß das genannte Phasenverriegelungsdetektionsmittel (300, 400) ein Entscheidungsmittel (17, 18, 19) umfaßt, zum Bestimmen, ob das genannte Phasenverriegelungsdetektionssignal (SG15) vorbestimmte Male synchron mit einer Veränderung des genannten Phasendifferenzsignals sukzessive erzeugt ist oder nicht, und zum Ausgeben eines Phasenverriegelungsdetektionssignals (SG16, SG17), das anzeigt, daß die genannte PLL-Synthetisiererschaltung definitiv in dem phasenverriegelten Zustand ist, wenn bestimmt ist, daß das genannte Phasenverriegelungsdetektionssignal die genannten vorbestimmten Male sukzessive erzeugt ist.

5. Eine PLL-Synthetisiererschaltung nach Anspruch 4, dadurch gekennzeichnet, daß das genannte Entscheidungsmittel m (m ist ganzzahlig und gleich oder größer als 2) Flipflops (17, 18), die seriell verbunden sind, und eine UND-Schaltung (19) umfaßt, in der:
jedes der genannten m Flipflops einen Eingangsanschluß, einen Ausgangsanschluß und einen Taktanschluß hat;
der Eingangsanschluß von einem der genannten m Flipflops in einer ersten Stufe mit dem Ausgangsanschluß des genannten dritten Flipflops verbunden ist;
der Ausgangsanschluß von jedem der genannten m Flipflops mit der genannten UND-Schaltung verbunden ist;
die genannte invertierte Version des genannten Referenztaktsignals auf den Taktanschluß von jedem der genannten m Flipflops angewendet wird; und
das genannte Phasenverriegelungsdetektionssignal, das anzeigt, daß die genannte PLL-Synthetisiererschaltung definitiv in dem phasenverriegelten Zustand ist, über die UND-Schaltung ausgegeben wird.

6. Eine PLL-Synthetisiererschaltung nach Anspruch 5, dadurch gekennzeichnet, daß die genannten m Flipflops jeweils aus D-Typ-Flipflops gebildet sind.

7. Eine PLL-Synthetisiererschaltung nach Anspruch 1, dadurch gekennzeichnet, daß das genannte Phasenverriegelungsdetektionsmittel (400) umfaßt:
erste, zweite, dritte und vierte Flipflops (13, 15, 21, 16), von denen jedes einen Eingangsanschluß, einen Ausgangsanschluß und einen Taktanschluß hat;
erste und zweite UND-Schaltungen (14, 22), von denen jede einen ersten Eingangsanschluß, einen zweiten Eingangsanschluß und einen Ausgangsanschluß hat; und
einen Inverter (20), und daß:
der Eingangsanschluß des genannten ersten Flipflops das genannte Phasendifferenzsignal empfängt;
der Ausgangsanschluß des genannten ersten Flipflops mit dem ersten Eingangsanschluß der genannten ersten UND-Schaltung verbunden ist;
der zweite Eingangsanschluß der genannten ersten UND-Schaltung das genannte Phasendifferenzsignal empfängt;
der Ausgangsanschluß der genannten ersten UND-Schaltung mit dem Eingangsanschluß des genannten zweiten Flipflops verbunden ist;
die ersten und zweiten Eingangsanschlüsse der genannten zweiten UND-Schaltung mit dem Ausgangsanschluß der genannten ersten UND-Schaltung bzw. dem Ausgangsanschluß des genannten zweiten Flipflops verbunden sind;
das genannte Bezugstaktsignal dem genannten Taktanschluß von jedem der genannten ersten, zweiten und dritten Flipflops zugeführt wird;
der Ausgangsanschluß des genannten dritten Flipflops mit dem Eingangsanschluß des genannten vierten Flipflops verbunden ist;
der Taktanschluß des genannten vierten Flipflops eine invertierte Version des genannten Phasendifferenzsignals empfängt, die durch den genannten Inverter erzeugt wurde; und
das genannte Phasenverriegelungsdetektionssignal über den Ausgangsanschluß des genannten vierten Flipflops ausgegeben wird.

8. Eine PLL-Synthetisiererschaltung nach Anspruch 7, dadurch gekennzeichnet, daß das genannte Phasenverriegelungsdetektionsmittel (400) ein Entscheidungsmittel (17, 18, 19) umfaßt, zum Bestimmen, ob das genannte Phasenverriegelungsdetektionssignal vorbestimmte Male synchron mit einer Veränderung des genannten Phasendifferenzsignals sukzessive erzeugt ist oder nicht, und zum Ausgeben eines Phasenverriegelungsdetektionssignals, das anzeigt, daß die genannte PLL-Synthetisiererschaltung definitiv in dem phasenverriegelten Zustand ist, wenn bestimmt ist, daß das genannte Phasenverriegelungsdetektionssignal die genannten vorbestimmten Male sukzessive erzeugt ist.

9. Eine PLL-Synthetisiererschaltung nach Anspruch 7, dadurch gekennzeichnet, daß die genannten ersten, zweiten, dritten und vierten Flipflops jeweils aus D-Typ-Flipflops gebildet sind.

10. Eine PLL-Synthetisiererschaltung nach Anspruch 1, dadurch gekennzeichnet, daß:
das genannte Phasenverriegelungsdetektionssignal einen ersten Pegel hat, der erhalten wird, wenn bestimmt ist, daß sich das genannte Bezugstaktsignal in der genannten Impulsbreite des genannten Phasendifferenzsignals nicht n-mal sukzessive ändert, und einen zweiten Pegel, der erhalten wird, wenn bestimmt ist, daß sich das genannte Bezugstaktsignal in der genannten Impulsbreite n-mal sukzessive ändert; und
welcher erste Pegel anzeigt, daß die genannte PLL-Synthetisiererschaltung in dem phasenverriegelten Zustand ist, und welcher zweite Pegel anzeigt, daß die genannte PLL-Synthetisiererschaltung in einem phasenentriegelten Zustand ist.

## Revendications

1. Circuit synthétiseur à boucle à phase asservie (à PPL) comprenant :
un moyen générateur de fréquence de référence (1, 2) servant à produire un signal de fréquence de référence (SG2) et un signal d'horloge de référence (SGqk) ;
un moyen de comparaison de phase (3) servant à comparer la phase dudit signal de fréquence de référence avec celle d'un signal de sortie (SG3) et à délivrer un signal de différence de phase (SG4) ayant une forme d'impulsion ; et
un moyen d'oscillation commandé en tension (4, 5, 6), couplé audit moyen de comparaison de phase, et servant à produire ledit signal de sortie ayant une fréquence qui dépend dudit signal de différence de phase,
un moyen de détection d'asservissement de phase (200, 300, 400) couplé audit moyen de comparaison de phase,
caractérisé en ce que ledit moyen de détection d'asservissement de phase comprend un moyen servant à déterminer si ledit signal de différence de phase possède ou non une largeur d'impulsion dans laquelle ledit signal d'horloge de référence change n fois successivement (n est un nombre égal ou supérieur à 2) et à délivrer un signal de détection d'asservissement de phase (SG15, SG16, SG17) qui signale que ledit circuit synthétiseur à PLL est dans un état asservi en phase lorsque ledit signal d'horloge de référence ne change pas n fois successivement dans ladite largeur d'impulsion dudit signal de différence de phase.

2. Circuit synthétiseur à PLL selon la revendication 1, caractérisé en ce que ledit moyen (200) de détection d'asservissement de phase comprend :
des première, deuxième et troisième bascules (13, 15, 16) ayant chacune une borne d'entrée, une borne de sortie et une borne d'horloge ;
un circuit ET (14) ayant une première borne d'entrée, une deuxième borne d'entrée et une borne de sortie ; et
un inverseur (20), et en ce que
la borne d'entrée de ladite première bascule reçoit ledit signal de différence de phase ;
la borne de sortie de ladite première bascule est connectée à la première borne d'entrée dudit circuit ET ;
la deuxième borne d'entrée dudit circuit ET reçoit ledit signal de différence de phase ;
la borne de sortie dudit circuit ET est connectée à la borne d'entrée de ladite deuxième bascule ;
ledit signal d'horloge de référence est fourni à ladite borne d'horloge de chacune desdites première et deuxième bascules ;
la borne de sortie de ladite deuxième bascule est connectée à la borne d'entrée de ladite troisième bascule ;
la borne d'horloge de ladite troisième bascule reçoit une version inversée dudit signal de différence de phase, produite par ledit inverseur ; et
le signal de détection d'asservissement de phase est délivré via la borne de sortie de ladite troisième bascule.

3. Circuit synthétiseur à PLL selon la revendication 2, caractérisé en ce que :
lesdites première, deuxième et troisième bascules (13, 15, 16) sont respectivement formées par des bascules de type D ;
lesdites première et troisième bascules de type D possèdent chacune une borne de sortie Q faisant fonction de leur borne de sortie respective ;
ladite deuxième bascule de type D possède une borne d'inversion Q̅ faisant fonction de la borne de sortie pour ladite deuxième bascule.

4. Circuit synthétiseur à PLL selon la revendication 1, caractérisé en ce que ledit moyen (300, 400) de détection d'asservissement de phase comprend un moyen de décision (17, 18, 19) servant à déterminer si ledit signal de détection d'asservissement de phase (SG15) a ou non été produit un nombre prédéterminé de fois successivement en synchronisme avec un changement dudit signal de différence de phase et à délivrer un signal de détection d'asservissement de phase (SG16, SG17) indiquant que ledit circuit synthétiseur à PLL se trouve définitivement dans l'état asservi en phase lorsqu'il a été déterminé que ledit signal de détection d'asservissement de phase a été produit ledit nombre prédéterminé de fois successivement.

5. Circuit synthétiseur à PLL selon la revendication 4, caractérisé en ce que ledit moyen de décision comprend m bascules (17, 18) connectées en série (m est un entier égal ou supérieur à 2 et un circuit ET (19), et en ce que :
chacune desdites m bascules possède une borne d'entrée, une borne de sortie et une borne d'horloge ;
la borne d'entrée de l'une desdites m bascules d'un premier étage est connectée à la borne de sortie de ladite troisième bascule ;
la borne de sortie de chacune desdites m bascules est connectée audit circuit ET ;
ladite version inversée dudit signal d'horloge de référence est appliquée à la borne d'horloge de chacune desdites m bascules ; et
ledit signal de détection d'asservissement de phase indiquant que ledit circuit synthétiseur à PLL est définitivement dans l'état asservi en phase est délivré via le circuit ET.

6. Circuit synthétiseur à PLL selon la revendication 5, caractérisé en ce que lesdites m bascules sont respectivement formées de bascules de type D.

7. Circuit synthétiseur à PLL selon la revendication 1, caractérisé en ce que ledit moyen (400) de détection d'asservissement de phase comprend :
des première, deuxième, troisième et quatrième bascules (13, 15, 21, 16) ayant chacune une borne d'entrée, une borne de sortie et une borne d'horloge ;
des premier et deuxième circuits ET (14, 22) ayant chacun une première borne d'entrée, une deuxième borne d'entrée et une borne de sortie ; et
un inverseur (20), et en ce que :
la borne d'entrée de ladite première bascule reçoit ledit signal de différence de phase ;
la borne de sortie de ladite première bascule est connectée à la première borne d'entrée dudit premier circuit ET ;
la deuxième borne d'entrée dudit premier circuit ET reçoit ledit signal de différence de base ;
la borne de sortie dudit premier circuit ET est connectée à la borne d'entrée de ladite deuxième bascule ;
les première et deuxième bornes d'entrée dudit deuxième circuit ET sont respectivement connectées à la borne de sortie dudit premier circuit ET et à la borne de sortie de ladite deuxième bascule ;
ledit signal de référence est fourni à ladite borne d'horloge de chacune desdites première, deuxième et troisième bascules ;
la borne de sortie de ladite troisième bascule est connectée à la borne d'entrée de ladite quatrième bascule ;
la borne d'horloge de ladite quatrième bascule reçoit une version inversée dudit signal de différence de phase, produite par ledit inverseur ; et
ledit signal de détection d'asservissement de phase est délivré via la borne de sortie de ladite quatrième bascule.

8. Circuit synthétiseur à PLL selon la revendication 7, caractérisé en ce que ledit moyen de détection d'asservissement de phase (400) comprend un moyen de décision (17, 18, 19) servant à déterminer si le signal de détection d'asservissement de phase a ou non été produit un nombre prédéterminé de fois successivement en synchronisme avec un changement dudit signal de différence de phase et à délivrer un signal de détection d'asservissement de phase indiquant que ledit circuit synthétiseur à PLL se trouve définitivement dans l'état asservi en phase lorsqu'il a été déterminé que ledit signal de détection d'asservissement de phase a été produit ledit nombre prédéterminé de fois successivement.

9. Circuit synthétiseur à PLL selon la revendication 7, caractérisé en ce que lesdites première, deuxième, troisième et quatrième bascules sont respectivement formées de bascules de type D.

10. Circuit synthétiseur à PLL selon la revendication 1, caractérisé en ce que :
ledit signal de détection d'asservissement de phase possède un premier niveau, qui est obtenu lorsqu'il a été déterminé que ledit signal d'horloge de référence ne varie pas n fois successivement dans ladite largeur d'impulsion dudit signal de différence de phase, et un deuxième niveau qui est obtenu lorsqu'il a été déterminé que ledit signal d'horloge de référence varie n fois successivement dans ladite largeur d'impulsion ; et
ledit premier niveau indiquant que ledit circuit synthétiseur à PLL est dans l'état asservi en phase, et ledit deuxième niveau indiquant que ledit circuit synthétiseur à PLL est dans un état non asservi en phase.
